# EUROPÄISCHE PATENTANMELDUNG

(11) **EP 0 530 450 A1**
(43) Veröffentlichungstag der Anmeldung: **10.03.1993**
(21) Anmeldenummer: 92109607.9
(22) Anmeldetag: 06.06.1992
(51) Int. Cl.: B29C 43/30, B29D 9/00

(54) **Kontinuierliche Herstellung von harzimprägnierten Materialbahnen**

(30) Priorität: 03.09.1991 DE 4129190
(71) Anmelder: Held, Kurt, D-78647 Trossingen (DE)
(72) Erfinder: Held, Kurt, D-78647 Trossingen (DE)

(57) **Zusammenfassung**

Die Erfindung betrifft ein Verfahren zur kontinuierlichen Herstellung von harzimprägnierten Materialbahnen, bei dem lösungsmittelarmes Harz zu einem Film extrudiert und dieser Film mit der Materialbahn zu einem Schichtgebilde zusammengeführt oder das Harz auf die Materialbahn aufgestreut wird. Das Schichtgebilde wird anschließend einem Flächendruck ausgesetzt. Die Vorrichtung zur Herstellung von harzimprägnierten Materialbahnen besteht aus einem Extruder (3) oder einer Streueinrichtung sowie einer einen Flächendruck ausübenden, kontinuierlich arbeitenden Doppelbandpresse (1).

## Beschreibung

Die Erfindung betrifft ein Verfahren zur kontinuierlichen Herstellung von harzimprägnierten Materialbahnen gemäß dem Oberbegriff des Patentanspruchs 1 oder 2 und eine Vorrichtung zur Durchführung dieses Verfahrens gemäß dem Oberbegriff des Patentanspruchs 19 oder 20.

Harzimprägnierte Materialbahnen werden zur Herstellung von Laminaten oder Schichtstoffen, wie dekorativen Laminaten für die Oberflächenbeschichtung von Spanplatten, kupferkaschierten Laminaten als Basismaterial für Leiterplatten, und dergleichen, benötigt. Bei der Laminatherstellung werden die harzimprägnierten Materialbahnen in der gewünschten Reihenfolge aufeinandergeschichtet und miteinander verpreßt. Üblicherweise werden Faser- oder Gewebebahnen als Materialbahnen verwendet, beispielsweise Papierbahnen, Glasgewebebahnen, Glasfasermatten, usw. Zur Imprägnierung der Materialbahnen dienen duroplastische Harze, wie Melamin-, Harnstoff-, Phenol-, Epoxidharze, sowie thermoplastische Harze.

Die Herstellung der harzimprägnierten Materialbahnen erfolgt in der Regel durch folgende Verfahrensschritte. Die Materialbahn wird von einer Rolle abgewickelt, durch ein Imprägnierbad und einem sich daran anschließenden Trockenkanal hindurchgeführt und danach auf eine Rolle aufgewickelt, die bis zur Weiterverarbeitung gelagert wird. Im Imprägnierbad befindet sich das Harz, das eventuell mit einem Härter und einem Beschleuniger versehen sein kann, in einem flüssigen Zustand. Dazu wird das Harz in einem Lösungsmittel gelöst. Als Lösungsmittel werden Wasser, Alkohole, Ester oder Kohlenwasserstoffe bzw. deren Mischungen verwendet. Handelt es sich um ein duroplastisches Harz, so ist dieses bis zu einem gewissen Grad, dem sogenannten A-Zustand, vorgehärtet. Beim Durchlaufen des Imprägnierbades wird die Materialbahn mit der Harzlösung durchtränkt. Das überschüssige Harz wird bei Verlassen des Imprägnierbades abgequetscht.

Im Trockenkanal wird durch Zufuhr von Wärme, beispielsweise mittels Infrarotstrahler oder eines heißen Luftstromes, das Lösungsmittel aus der Materialbahn entfernt. Gleichzeitig härtet das duroplastische Harz bis zum sogenannten B-Zustand weiter. Bei dem B-Zustand handelt es sich um eine Reaktion des Harzes, die in einen stabilen, jedoch noch schmelzbaren Zustand für das Harz führt. Die Herstellung der harzimprägnierten Materialbahn, die auch als Prepreg bezeichnet wird, ist danach abgeschlossen.

Bei der späteren Verpressung der harzimprägnierten Materialbahnen, die beispielsweise in einer Doppelbandpresse kontinuierlich oder in einer Etagenpresse diskontinuierlich durchgeführt werden kann, härtet das duroplastische Harz schließlich vollständig bis zum C-Zustand aus und verbindet die einzelnen Schichten zum kompakten Laminat.

Dieser Stand der Technik wird beispielsweise in Kunststoff-Handbuch, Band XI, Seite 166 bis 167, erschienen in Carl Hanser Verlag, München, 1971 beschrieben.

Nachteilig bei dem beschriebenen Verfahren ist, daß zur Erzielung des flüssigen, das Eindringen in die Materialbahn ermöglichenden Zustandes des Harzes im Imprägnierbad ein Lösungsmittel benötigt wird. Dieses Lösungsmittel muß jedoch anschließend im Trocknungskanal entfernt werden, was zu beträchtlichen Umweltbelastungen führt. Darüber hinaus kann das Lösungsmittel meistens nicht vollständig entfernt werden, so daß bei der späteren Verpressung der Materialbahnen zum Laminat Einschlüsse des Lösungsmittels im Laminat verbleiben, die wiederum die Qualität des Laminats herabsetzen. Weiter hat es sich gezeigt, daß die Beharzung sehr oft flächenmäßig ungleichmäßig ist, was letztendlich zu Schwankungen in den Eigenschaften der Laminate führt. Das Harz dringt zum Teil in die Fasern der Materialbahnen nur ungenügend ein, so daß lediglich ein schlechter Verbund zwischen den einzelnen Schichten des Laminates entsteht. Außerdem werden sehr lange Trocknungskanäle benötigt, bis das Harz zum B-Zustand weitergehärtet ist, was die Anlagen zur Herstellung von harzimprägnierten Materialbahnen stark verteuert.

Aus der DE-OS 38 34 993 ist ein Verfahren bekannt geworden, bei dem die unbeharzte Materialbahn von einer Rolle abgewickelt und auf das von der Auslaufzone in die Einlaufzone einer Doppelbandpresse rücklaufende Bandtrum eines Preßbandes aufgelegt wird. Zuvor oder danach wird die Materialbahn mit einem lösungsmittelarmen Harz versehen. Das rücklaufende Bandtrum ist beheizt, so daß auf die mit Harz versehene Materialbahn Wärme einwirkt und die Imprägnier- und Trocknungsprozesse für die Materialbahn auf dem rücklaufenden Bandtrum stattfinden. Am Einlauf in die Doppelbandpresse wird die beharzte Materialbahn mit den übrigen Materialbahnen zusammengeführt und anschließend in der Doppelbandpresse unter Wärme- und Druckeinwirkung zum Laminat verpreßt.

Bei diesem Verfahren ist die Imprägnierung der Materialbahnen mit Harz sowie die Verpressung der Materialbahnen zum Laminat in ein einstufiges Verfahren integriert. Um bei der Verpressung ein vollständig bis zum C-Zustand ausgehärtetes Laminat zu erhalten, müssen die Preßbänder der Doppelbandpresse mit einer vom Zustand und der Art des Harzes abhängigen Vorschubgeschwindigkeit betrieben werden. Systembedingt finden damit die auf dem rücklaufenden Bandtrum durchgeführten Imprägnier- und Trocknungsprozesse mit derselben Geschwindigkeit statt. Diese Geschwindigkeit ist aber im allgemeinen nicht diejenige, bei der optimal bis zum B-Zustand gehärtete harzimprägnierte Materialbahnen bis zum Einlauf in die Doppelbandpresse erhalten werden, so daß es vorkommen kann, daß Vor- und Aushärtungsbedingungen am rücklaufenden Bandtrum bzw. in der eigentlichen Reaktionszone der Doppelbandpresse in einem durch die gegebenen Abmessungen der Maschine fixierten, für die jeweils optimierten Härtungsbedingungen jedoch ungünstigen, weil unveränderlichen Verhältnis stehen. Damit besteht die Gefahr, qualitativ nicht den Ansprüchen genügende Laminatbahnen zu erzeugen.

Laminate setzen sich in vielen Fällen aus mehr als zwei harzimprägnierten Materialbahnen zusammen. Beispielsweise können für den Schichtstoffkern von kupferkaschierten Laminaten zwischen acht und zehn mit Epoxidharz imprägnierte Glasgewebebahnen erforderlich sein. Damit müssen die Imprägnier- und Trocknungsprozesse von mehreren Materialbahnen auf jeden der beiden rücklaufenden Bandtrums der beiden Preßbänder der Doppelbandpresse gleichzeitig durchgeführt werden. Da die Materialbahnen dabei übereinanderliegen, hat es sich gezeigt, daß die Materialbahnen ungleichmäßig und nicht ausreichend imprägniert und vorgehärtet sind. Dadurch resultieren wiederum qualitativ minderwertige Laminate.

Obwohl das einstufige Verfahren gemäß der DE-OS 38 34 993 den Einsatz von lösungsmittelarmen Harzen ermöglicht, hat sich dieses Verfahren noch nicht durchsetzen können. Der Grund dafür liegt auch in der Tatsache begründet, daß sowohl für den Betrieb der mit Etagenpressen eingerichteten, bestehenden Produktionsstätten als besonders auch für die Verklebung von Multilayer-Leiterplatten immer noch große, in Zukunft sogar steigende Mengen Prepreg benötigt werden, die in Bogen verpreßt werden müssen.

Ausgehend von diesem Stand der Technik besteht die Aufgabe der Erfindung darin, die Herstellung von harzimprägnierten Materialbahnen so zu verbessern, daß eine über die Fläche gleichmäßige und vollständig in die Fasern der Materialbahnen eindringende Harzimprägnierung unter Verwendung von lösungsmittelfreiem Harz gewährleistet ist.

Die Lösung dieser Aufgabe wird durch die im Kennzeichen des Patentanspruchs 1 oder 2 beschriebene technische Lehre vermittelt. Eine zur Durchführung dieses Verfahrens dienende Vorrichtung wird im Kennzeichen des Patentanspruchs 19 oder 20 angegeben.

Die mit der Erfindung erzielbaren Vorteile bestehen insbesondere darin, daß kein oder allerhöchstens geringe Mengen an Lösungsmittel verwendet werden müssen und die damit verbundenen Umweltprobleme entfallen. Die harzimprägnierten Materialbahnen besitzen weder Einschlüsse von Luft noch von Lösungsmittel und sind somit vollständig blasenfrei. Dadurch verbessern sich die technologischen Eigenschaften der Laminate. Das erfindungsgemäße Verfahren liefert harzimprägnierte Materialbahnen, bei denen das Flächengewicht des eingebrachten Harzes innerhalb eines weitaus engeren Toleranzbereiches als bisher liegt, was ebenfalls zur Verbesserung der qualitativen Eigenschaften der Laminate führt. Die Imprägnierung kann zudem bei höheren Temperaturen als in herkömmlichen Imprägnieranlagen durchgeführt werden, womit eine höhere Imprägniergeschwindigkeit erzielt wird. Dadurch wird der Ausstoß der Anlage gesteigert und die Anlage kann kürzer und folglich billiger gebaut werden. Damit führt die Erfindung auch zu einer größeren Wirtschaftlichkeit bei der Herstellung von harzimprägnierten Materialbahnen.

Ein Ausführungsbeispiel für eine Vorrichtung zur Durchführung des erfindungsgemäßen Verfahrens ist in den Zeichnungen dargestellt und wird im folgenden näher beschrieben. Es zeigen
- Figur 1: die Gesamtansicht einer Vorrichtung zur kontinuierlichen Herstellung von harzimprägnierten Materialbahnen,
- Figur 2: einen Schnitt durch eine Doppelbandpresse mit vorgeschaltetem Extruder gemäß der Vorrichtung aus Figur 1
- Figur 3: eine Druckplatte der Doppelbandpresse in Draufsicht,
- Figur 4: einen Schnitt durch die Druckplatte entlang der Linie A-A in Figur 3,
- Figur 5: die Einlaufzone einer Doppelbandpresse in einer weiteren Ausführungsform für das Verfahren zur Herstellung von harzimprägnierten Materialbahnen,
- Figur 6: die Einlaufzone einer Doppelbandpresse in einer weiteren Ausführungsform,
- Figur 7: die Einlaufzone einer Doppelbandpresse in noch einer weiteren Ausführungsform und
- Figur 8: die Einlaufzone einer Doppelbandpresse in einer nochmals anderen Ausführungsform.

Die Erfindung wird im folgenden an einer Vorrichtung zur kontinuierlichen Herstellung von Prepregs aus mit Epoxidharz imprägnierten, bis zum B-Zustand vorgehärteten Glasfasergewebebahnen erläutert. Diese Prepregs dienen bei der Herstellung von kupferkaschierten Laminaten zur Ausbildung der isolierenden Kernschicht zwischen den beiden Kupferfolien. Bei der späteren Verpressung der Prepregs mit den Kupferfolien in einer kontinuierlich arbeitenden Doppelbandpresse oder diskontinuierlich arbeitenden Etagenpresse härtet das Epoxidharz bis zum C-Zustand vollständig aus und verbindet die einzelnen Schichten miteinander zum kompakten Laminat. Das kupferkaschierte Laminat dient nun wiederum als Ausgangsmaterial für die Herstellung von Leiterplatten.

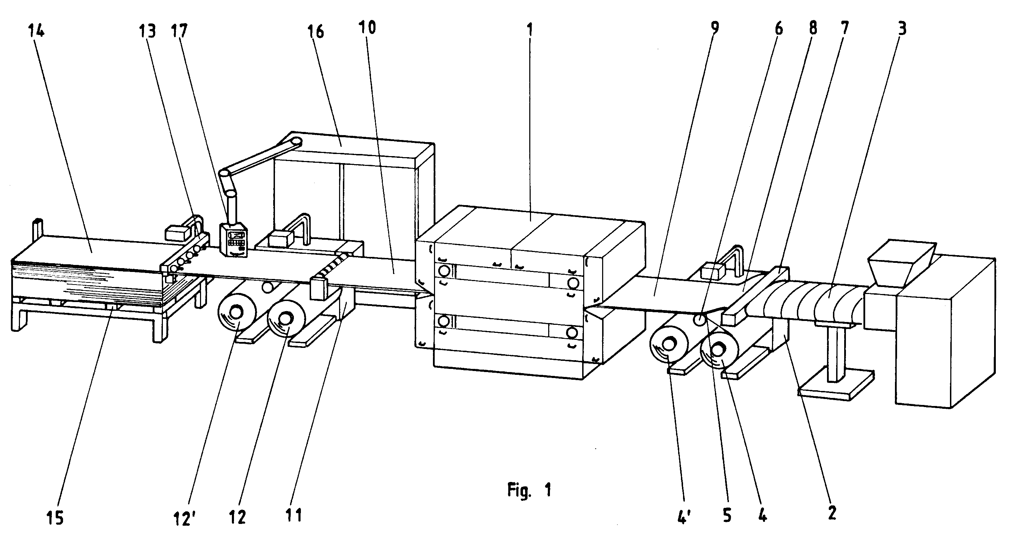

In Figur 1 ist eine Vorrichtung zur kontinuierlichen Herstellung von Prepreg-Bahnen schematisch dargestellt. Sie besteht aus einer Doppelbandpresse 1, vor deren Einlauf sich eine Abwickeleinheit 2 und ein Extruder 3 befinden. In der Abwickeleinheit 2 befindet sich eine Vorratsrolle 4 und Ersatzrolle 4' mit unbeharzten Glasfasergewebe. In der Nähe der Abwickeleinheit 2 ist ein Extruder 3 zur Erzeugung einer Epoxidharz-Schmelze angeordnet. Hinter der Doppelbandpresse 1 befindet sich eine Aufwickeleinheit 11 mit einer Rolle 12 und Ersatzrolle 12' für die Prepreg-Bahn 10. Alternativ oder falls gewünscht auch zusätzlich kann die Prepreg-Bahn 10 in einer Querschneideeinheit 13 in bogenförmige Abschnitte 14 von beliebiger Größe aufgeteilt werden, die in Paletten 15 zum Abtransport gestapelt werden. Eine solche Vorgehensweise kann sich anbieten, wenn das Prepreg später in einer diskontinuierlich arbeitenden Etagenpresse zu abschnittsförmigen Kupferlaminat weiterverarbeitet wird. Die gesamte Vorrichtung wird von einem Computer in einem Schaltschrank 16 gesteuert. Die Dateneingabe durch den Benutzer erfolgt über das Terminal 17. Insbesondere werden am Terminal 17 die Temperaturen im Extruder 3 und in der Doppelbandpresse 1 sowie die Vorschubgeschwindigkeit der Prepreg-Bahn 10 vom Benutzer eingestellt und vom Computer gesteuert.

Entsprechend dem erfindungsgemäßen Verfahren wird von der Vorratsrolle 4 in der Abwickeleinheit 2 die unbeharzte Glasfasergewebe-Bahn 5 kontinuierlich abgezogen und über eine Umlenkrolle 6 der Doppelbandpresse 1 zugeführt. In der Abwickeleinheit 2 befindet sich noch eine weitere Vorratsrolle 4', von der die Glasfasergewebe-Bahn 5 abgewickelt wird, sobald die Glasfasergewebe-Bahn 5 von der Vorratsrolle 4 zu Ende geht. Damit ist ein unterbrechungsfreier Betrieb der gesamten Vorrichtung gewährleistet. Im Extruder 3 wird das Epoxidharz aufgeschmolzen und die Schmelze über eine Breitschlitzdüse 7 des Extruders 3 als Film 8 in der Nähe der Umlenkrolle 6 auf die Glasfasergewebe-Bahn 5 aufgebracht. Dieses Schichtgebilde 9 aus Glasfasergewebe-Bahn 5 und Epoxidharz-Film 8 wird dann in die Doppelbandpresse 1 eingeführt und in dieser unter Einwirkung von Flächendruck erwärmt. Dabei dringt die Epoxidharz-Schmelze in die Glasfasergewebe-Bahn ein und härtet bis zum B-Zustand weiter. Zur weiteren Erhöhung der Qualität kann das Schichtgebilde anschließend in der Doppelbandpresse 1 noch unter Einwirkung von Flächendruck abgekühlt werden. Die Kühlung kann auch dadurch notwendig werden, daß die vorgehärtete Epoxidharzschmelze im B-Zustand am Ende der beheizten Reaktionszone bei der darin herrschenden Temperatur immer noch zähflüssig-klebrig ist. Dann muß der Prepreg in einer an die beheizte Reaktionszone unmittelbar sich anschließenden gekühlten Reaktionszone unter die Erweichungstemperatur < 60 °C gekühlt werden, damit er sich von den Preßbandflächen rückstandsfrei ablösen läßt. Am Auslauf der Doppelbandpresse 1 verläßt die bis zum B-Zustand vorgehärtete, mit Epoxidharz imprägnierte Glasfasergewebe-Bahn, die sogenannte Prepreg-Bahn 10, die Doppelbandpresse 1 klebfrei abgekühlt und wird in der Rolle 12 der Aufwickeleinheit 11 kontinuierlich aufgewickelt. Ist die Rolle 12 gefüllt, so kann ohne Produktionsunterbrechung die Prepreg-Bahn 10 auf eine Ersatzrolle 12' aufgewickelt werden. Alternativ kann, wie bereits erwähnt, die Prepreg-Bahn 10 auch in bogenförmige Abschnitte 14 aufgeteilt werden.

Aufgrund von elektrostatischer Anziehung können sich hinter der Doppelbandpresse 1 Staubpartikel auf der Prepreg-Bahn 10 absetzen, die bei der späteren Verpressung zu Fehlstellen im Laminat führen können. Daher kann es notwendig sein, Spitzenionisatoren zur Verminderung der elektrostatischen Aufladung an der Prepreg-Bahn 10 hinter der Doppelbandpresse 1 anzuordnen.

Bei dem für die Extrusion verwendeten Epoxid-Harz handelt es sich um ein Gemisch aus Flocken oder Pulver von Festharz, das keine Lösungsmittel oder allerhöchstens einen geringen Anteil an Lösungsmittel enthält. Es besteht in der Regel aus mehreren Komponenten. Beispielsweise kann es sich um ein Gemisch von niedermolekularen, zum A-Zustand gehärteten Epoxidharz, bromierten Epoxidharz, Härter, Beschleuniger und eventuell noch weiteren Zusätzen handeln. Diese einzelnen Komponenten werden im gewünschten gravimetrischen Verhältnis miteinander vermischt. Für qualitativ hochwertige kupferkaschierte Laminate werden die Komponenten so gewählt, daß ein Epoxidharz-System in FR4-Qualität, das heißt nicht brennbar und dem US-Standard NEMA-LI1 entsprechend, entsteht.

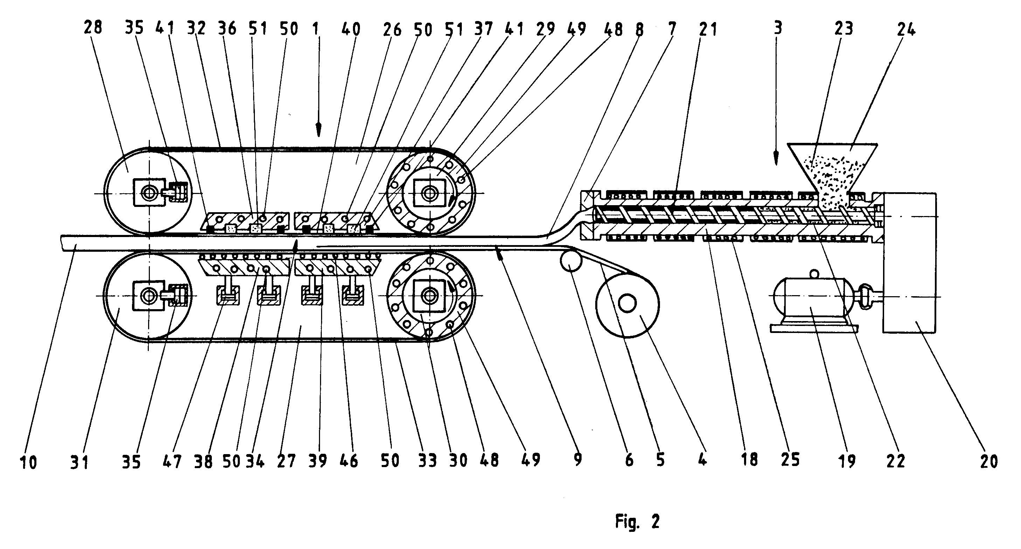

Die Figur 2 zeigt den zur Erzeugung der Epoxidharz-Schmelze verwendeten Extruder 3 mit nachgeschalteter Doppelbandpresse 1 schematisch im Schnitt. Der wie bekannt ausgebildete Extruder 3 besitzt einen länglichen Zylinder 18, in dem sich eine von einem Motor 19 über ein Reduziergetriebe 20 angetriebene Schnecke 21 befindet. Die Schnecke 21 nimmt in ihrem hinteren Teil in ihren wendelförmigen Vertiefungen 22 das aufzuschmelzende Gemisch aus Flocken oder Pulver von Epoxidharz 23 auf, das in einen Trichter 24 des Extruders 3 gefüllt wird. Das Epoxidharz 23 wird mit der Schnecke 21 weitertransportiert und während dieses Transports aufgeschmolzen. Dazu sind um den Zylinder 18 mehrere Heizmanschetten 25 gelegt. Bei der Förderung des Epoxidharzes 23 durch den Zylinder 18 wird das Epoxidharz 23 erwärmt, aufgeschmolzen und verdichtet, so daß es am vorderen Ende der Schnecke 21 eine homogene, viskoelastische Schmelze bildet. Die Epoxidharz-Schmelze tritt durch die am vorderen Teil des Zylinders 18 angeflanschte Breitschlitzdüse 7 als flacher, im wesentlichen einen rechteckförmigen Querschnitt besitzender Film 8 aus. In der Regel wird dieser Film 8 eine Verarbeitungstemperatur von 100 bis 150 °C, vorzugsweise 130 °C besitzen.

Zur Gewährleistung einer gleichmäßigen Imprägnierung der Glasfasergewebe-Bahn 5 mit einem konstanten Flächengewicht besitzt der Extruder 3 eine lippengeregelte Breitschlitzdüse 7.

Bei solch einer lippengeregelten Breitschlitzdüse 7 ist das Profil der Düse einstellbar, so daß eine Homogenisierung des aus der Breitschlitzdüse 7 austretenden Filmes 8 aus Epoxidharz-Schmelze möglich ist. Die Profileinstellung der Breitschlitzdüse 7 erfolgt wiederum in Abhängigkeit des Flächengewichtes des im Glasfasergewebe der Prepreg-Bahn 10 befindlichen Harzes. Dieses Flächengewicht wird mittels eines Meßsystems ermittelt, das aus einer vor der Doppelbandpresse 1, an der Glasfasergewebe-Bahn 5 angeordneten Beta-Strahlers und einem hinter der Doppelbandpresse 1, an der Prepreg-Bahn 10 angeordneten Beta-Strahler besteht. Beide Beta-Strahler sind quer über die Breite der Glasfasergewebe-Bahn 5 oder Prepreg-Bahn 10 bewegbar. Mittels eines Detektors wird die Intensität der Rückstreustrahlung oder der Durchstrahlung der Beta-Strahlen berechnet und daraus nach bekannten Gesetzmäßigkeiten das Flächengewicht des im Prepreg befindlichen Harzes berechnet. Aufgrund des so ermittelten Flächengewichts kann weiter der Massendurchsatz des Extruders an geschmolzenem Harz durch Einstellung der Geschwindigkeit der Schnecke 10 und der Heizmanschnetten 25 geregelt werden.

Die kontinuierlich arbeitende Doppelbandpresse 1, in die das Schichtgebilde 9 aus Epoxidharz-Schmelze-Film 8 und Glasfasergewebe-Bahn 5 einläuft, wird ebenfalls in Figur 2 im Schnitt näher gezeigt. Sie besteht aus einer oberen Preßbandeinheit 26 und unteren Preßbandeinheit 27. Die Preßbandeinheiten 26, 27 setzen sich aus je zwei Umlenktrommeln 28, 29 bzw. 30, 31 und je einem endlosen Preßband 32, 33 zusammen, das um die Umlenktrommeln 28, 29 bzw. 30, 31 herumgeführt ist. Die vier Umlenktrommeln 28, 29, 30, 31 sind in einem in der Zeichnung aus Übersichtlichkeitsgründen nicht dargestellten Pressengestell drehbar gelagert, so daß sich die beiden Preßbänder 32, 33 entsprechend den Pfeilen in den Umlenktrommeln 29, 30 bewegen. Die gewöhnlicherweise aus einem hochzugfesten Stahlband bestehenden Preßbänder 32, 33 werden mit bekannten Mitteln, beispielsweise Hydraulikzylindern 35 gespannt.

Zwischen dem unteren Trum des oberen Preßbandes 32 und dem oberen Trum des unteren Preßbandes 33 liegt die Reaktionszone 34, in der das in der Zeichnung von rechts nach links vorlaufende Schichtgebilde 9 unter Flächendruck bearbeitet wird. Der in der Reaktionszone 34 der Doppelbandpresse 1 ausgeübte Flächendruck wird über Druckplatten 36, 37 hydraulisch oder über Druckplatten 38, 39 mechanisch auf die Innenseiten der Preßbänder 32, 33 aufgebracht und von diesen dann auf das zu verpressende Schichtgebilde 9 übertragen. Die vom Schichtgebilde 9 ausgeübten Reaktionskräfte werden über die Druckplatten 36, 37, 38, 39 wiederum in das Pressengestell eingeleitet.

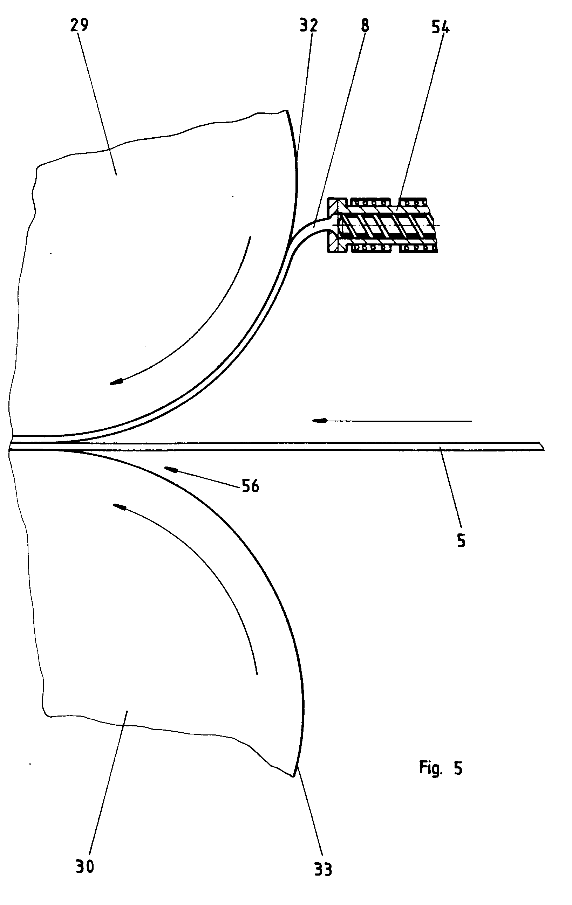

Bei der hydraulischen Druckübertragung wird ein unter Druck setzbares fluides Druckmedium in eine Druckkammer 40 eingebracht, wie in Figur 2 anhand der oberen Preßbandeinheit 26 gezeigt ist. Die Druckkammer 40 ist von der Druckplatte 36, 37, der Innenseite des Preßbandes 32 und seitlich von einer ringförmig in sich geschlossenen, in der Druckplatte 36, 37 angeordneten Gleitflächendichtung 41 begrenzt. Der Aufbau der entlang des Randes der Druckplatte 36, 37 rechteckförmig in sich geschlossenen Gleitflächendichtung 41 ist in Figur 4 näher zu sehen. Sie besteht aus einer U-förmigen Halteleiste 42 aus Metall, in die der elastische Dichtkörper 43 eingeklemmt ist. Die U-förmige Halteleiste 42 befindet sich in einer Nut 44 entlang des Randes der Druckplatte 36, 37. Auf der Halteleiste 42 liegt dem Nutgrund zu ein O-Ring 45, auf den vom Nutgrund her ein Druckmedium einwirkt, so daß der Dichtkörper 43 gegen die Innenseite des Preßbandes 32 gedrückt wird und die Druckkammer 40 zu den Seiten hin abdichtet. Als Druckmedium für die Druckkammer 40 wird vorzugsweise ein synthetisches Öl verwendet. Genausogut kann jedoch auch ein Gas, beispielsweise Druckluft verwendet werden.

Zur mechanischen Erzeugung des Flächendrucks sind zwischen der Druckplatte 38, 39 und der Innenseite des Preßbandes 33 ortsfeste Rollen 46 angeordnet, wie in Figur 2 an der unteren Preßbandeinheit 27 gezeigt ist. Mit Hilfe von Hydraulikzylindern 47 wird die Druckplatte 38, 39 mitsamt den Rollen 46 gegen die Innenseite des Preßbandes 33 angestellt.

Selbstverständlich kann auch die Druckplatte 36, 37 mit einem mechanischen Druckübertragungssystem bzw. die Druckplatte 38, 39 mit einem hydraulischen Druckübertragungssystem versehen sein. Falls gewünscht, kann die Druckübertragung auch kombiniert hydraulisch/mechanisch erfolgen, indem die beiden geschilderten Prinzipien gleichzeitig angewandt werden. Näheres zur kombiniert hydraulischen/mechanischen Druckübertragung läßt sich der DE-OS 33 04 754 entnehmen.

Während der Ausübung des Flächendrucks auf das Schichtgebilde 9 in der Reaktionszone 34 der Doppelbandpresse 1 wird das Schichtgebilde 9 zunächst gleichzeitig erwärmt. Zur Übertragung der benötigten Wärme sind die einlaufseitigen Umlenktrommeln 29, 30 beheizbar ausgebildet. Dazu befinden sich Kanäle 48 im Mantel 49 der einlaufseitigen, zylindrischen Umlenktrommeln 29, 30. Durch die Kanäle 48 zirkuliert ein Wärmeträgermittel, beispielsweise ein Thermoöl, das durch Konvektion Wärme an die Umlenktrommeln 29, 30 abgibt. Die Wärme der Umlenktrommeln 29, 30 wird von diesen auf die Preßbänder 32, 33 übertragen und vom Preßband 32, 33 schließlich in der Reaktionszone 34 an das Schichtgebilde 9 abgegeben. Anstelle der Erwärmung mittels eines in den Kanälen 48 zirkulierenden Wärmeträgermittels können auch elektrisch betriebene Heizpatronen in den Mänteln 49 der einlaufseitigen Umlenktrommeln 29, 30 angeordnet sein.

Zur weiteren Erwärmung des Schichtgebildes 9 in der Reaktionszone 34 oder alternativ können wenigstens die einlaufseitig angeordneten Druckplatten 37, 39 als Heizplatten ausgebildet sein. Zu diesem Zweck befinden sich Kanäle 50 in den Druckplatten 37, 39, die ebenfalls von einem Wärmeträgermittel durchflossen werden. Das Wärmeträgermittel gibt während der Strömung durch die Kanäle 50 Wärme mittels konvektiver Wärmeübertragung an die Druckplatten 37, 39 ab. Die Druckplatten 37, 39 werden dabei auf eine Temperatur erwärmt, die höher als die Temperatur der Preßbänder 32, 33 in der Reaktionszone 34 ist. Die Erwärmung der Druckplatten 37, 39 kann auch durch elektrische Heizelemente erfolgen.

Bei der mechanischen Druckübertragung wird dann aufgrund des Wärmegefälles Wärme von der Druckplatte 39 auf das Preßband 33 über die Rollen 46, die aus einem gut wärmeleitfähigen Metall bestehen, übertragen. Bei der hydraulischen Druckübertragung sind in der Druckplatte 37 wärmeleitende Elemente 51 angeordnet. Diese wärmeleitenden Elemente 51 bestehen aus einem gut wärmeleitfähigen Material, besitzen mit einer Fläche einen guten Wärmeleitkontakt zu der Druckplatte 37 und berühren mit einer weiteren Fläche die Innenseite des Preßbandes 32, so daß die Innenseite des Preßbandes 32 an dieser Fläche der wärmeleitenden Elemente 51 entlanggleitet. Aufgrund des Wärmegefälles zwischen der Druckplatte 37 und dem Preßband 32 wird somit Wärme von der Druckplatte 37 über die wärmeleitenden Elemente 51 auf das Preßband 32 übertragen. Sollte die Größe des Wärmestromes über die Rollen 46 nicht ausreichen, so können solche zusätzlichen wärmeleitenden Elemente 51 auch zwischen den Rollen 46 angeordnet werden. Die Wärme wird vom Preßband 32 schließlich an das Schichtgebilde 9 weitergegeben.

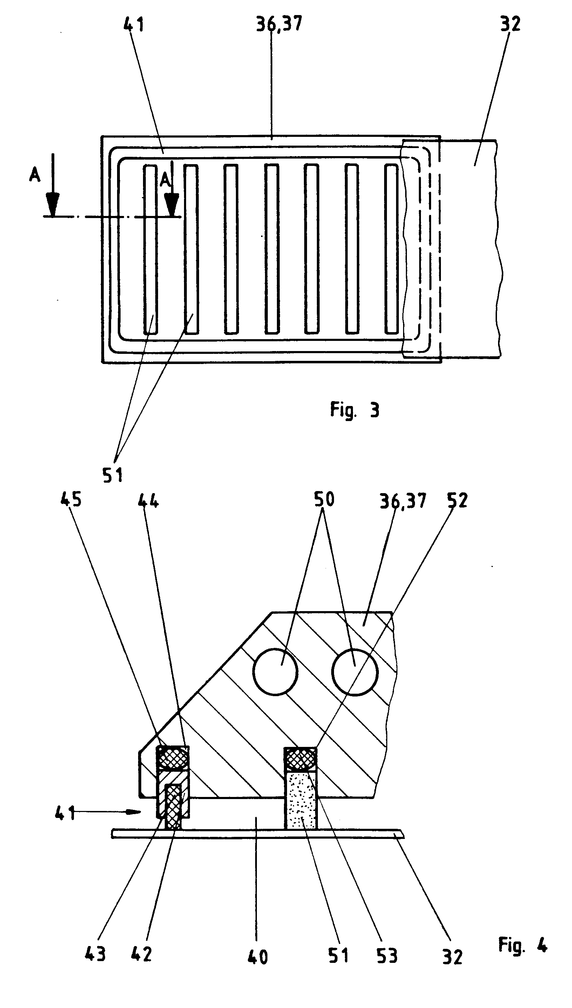

Stabförmig ausgebildete wärmeleitende Elemente, die quer über die Druckplatte 36, 37 reichen, sind in Figur 3 und 4 näher zu sehen. In der Druckplatte 36, 37 befinden sich quer zur Vorschubrichtung des Preßbandes 32 angebrachte Nuten 52. In diese Nuten 52 sind stabförmige wärmeleitende Elemente 51 so eingesetzt, daß sie unter Ausbildung eines guten Wärmeleitkontaktes die Wand der Nut 52 berühren. Dem Nutgrund der Nut 52 zu liegt auf dem wärmeleitenden Element 51 eine elastomere Dichtung 53 auf, die vom Nutgrund her mit einem Druckmittel beaufschlagt wird, so daß das wärmeleitende Element 51 immer Kontakt mit dem Preßband 32 besitzt. Das wärmeleitende Element 51 besteht aus Kupfer. Die nähere Ausbildung der wärmeleitenden Elemente sowie weitere Ausführungsformen sind aus der DE-OS 33 25 578 oder der DE-OS 39 21 364 an sich bekannt und brauchen daher hier nicht näher erläutert zu werden.

Anschließend an die Erwärmung kann, falls gewünscht, in der Doppelbandpresse eine Zone folgen, in der das Schichtgebilde 9 unter Einwirkung von Flächendruck noch abgekühlt wird. Dazu sind die Druckplatten 36, 38 als Kühlplatten ausgebildet, indem durch die Kanäle 50 ein gekühltes Wärmeträgermittel geleitet wird, so daß die Druckplatten 36, 38 auf einer Temperatur gehalten werden, die sehr viel geringer als die zu erreichende Endtemperatur der Prepreg-Bahn 10 ist. Über wärmeleitende Elemente 51 oder die Rollen 46 fließt ein Wärmestrom vom Preßband 32, 33 auf die Druckplatte 36, 38. Die Kühlflüssigkeit nimmt die Wärme aus der Druckplatte 36, 38 auf und führt diese ab, womit die Solltemperatur der Druckplatte 36, 38 auf dem gewünschten niedrigen Niveau gehalten wird. Selbstverständlich kann die Kühlung der Druckplatte 36, 38 auch elektrisch, beispielsweise mittels Peltier-Elementen erfolgen.

Das Schichtgebilde 9, das aus der auf Zimmertemperatur befindlichen Glasfasergewebe-Bahn 5 und dem auf ca. 120 bis 130 ⁰C erwärmten Film 8 aus Epoxidharz besteht, wird in der Reaktionszone 34 der Doppelbandpresse 1 zunächst zwischen den Druckplatten 37 und 39 weiter erwärmt. Die Erwärmung wird dabei bis zu einer Temperatur zwischen 220 und 350 ⁰C, vorzugsweise 300 °C, fortgesetzt. Durch die Wärmeeinwirkung erniedrigt sich die Viskosität der Epoxidharz-Schmelze weiter und das Epoxidharz dringt verstärkt durch die Einwirkung des Flächendrucks in die Hohlräume der Glasfasergewebe-Bahn 5 ein und benetzt die Glasfasern vollständig. Gleichzeitig härtet das Epoxidharz dabei weiter aus. Anschließend durchläuft das Schichtgebilde 9 die gekühlte Reaktionszone 34 zwischen den beiden Druckplatten 36 und 38.

Das Schichtgebilde wird dabei abgekühlt, wobei die Abkühlung auf 40 bis 80 ⁰C, vorzugsweise unter 60 °C durchgeführt wird, so daß die Prepreg-Bahn 10 die Doppelbandpresse 1 in klebefreiem Zustand verläßt. Sollte dennoch die Trennung der Prepreg-Bahn 10 von den Preßbändern 32, 33 Schwierigkeiten bereiten, können die Preßbänder 32, 33 mit einer Trennschicht, beispielsweise aus Teflon, versehen werden oder eine Trennfolie kann durch die Doppelbandpresse 1 zusammen mit dem Schichtgebilde 9 hindurchgeführt werden. Die Durchlaufgeschwindigkeit des Schichtgebildes 9 durch die Doppelbandpresse 1 wird so gewählt, daß die Prepreg-Bahn 10 bei Verlassen der Doppelbandpresse 1 vollständig mit Epoxidharz imprägniert und bis zum B-Zustand vorgehärtet ist. Unter Umständen kann sogar eine Abkühlung der Prepreg-Bahn 10 in der Doppelbandpresse 1 entfallen, das heißt das Schichtgebilde 9 wird lediglich unter Einwirkung von Flächendruck in der Doppelbandpresse 1 erwärmt.

Es hat sich gezeigt, daß mit dem Verfahren gemäß der Erfindung qualitativ weitaus bessere Prepregs als mit dem herkömmlichen Verfahren herstellbar sind. In dem die Doppelbandpresse 1 verlassenden Prepreg sind keinerlei Luft- oder Gaseinschlüsse zu sehen, die die technischen Eigenschaften des daraus hergestellten Laminats, wie Dielektrizitätskonstante, Festigkeit, usw. herabsetzen. Vielmehr sind die Prepregs völlig klar. Es wird vermutet, daß unter der Einwirkung des Flächendrucks eine sehr viel bessere Resorption von eingeschlossenen Gasen und Luft im Harz stattfindet, so daß sich Luft- oder Gasblasen nicht ausbilden können. Bei dem erfindungsgemäßen Verfahren kann das bisher kaum einsetzbare lösungsmittelfreie Festharz verwendet werden, so daß weder Lösungsmittel aus verfahrenstechnischen Gründen benötigt werden noch überhaupt Lösungsmitteldämpfe anfallen, die bei dem herkömmlichen Verfahren zu einer beträchtlichen Umweltbelastung führen. Da in der Heizzone der Doppelbandpresse sehr hohe Temperaturen bis mindestens 300 °C angewendet werden können, ohne daß sich bisher eine Schädigung des Harzes gezeigt hat, kann das Verfahren bei sehr hohen Vorschubgeschwindigkeiten und damit äußerst wirtschaftlich ablaufen.

In der beschriebenen erfindungsgemäßen Vorrichtung besteht die Möglichkeit, in der Reaktionszone 34 der Doppelbandpresse 1 ein der Sorte des verwendeten Harzes optimal angepaßtes Temperaturprofil einzustellen. Dazu werden die Druckplatten 37, 39 bzw. 36, 38 in einzelne Druckplatten eingeteilt und jede dieser einzelnen Druckplatte auf einer bestimmten Temperatur des Temperaturprofils gehalten. Dadurch gelingt eine gezielte Viskositätseinstellung des Harzes, was zu einer besonders guten Benetzung der Glasfasergewebebahn führt.

In Figur 5 ist der Einlaufbereich einer Doppelbandpresse gemäß einer weiteren Ausführungsform der Erfindung zu sehen. Hier ist der Extruder 54 in der Nähe der oberen einlaufseitigen Umlenktrommel 29 angeordnet. Der Film 8 aus Epoxidharz-Schmelze wird auf das an der Umlenktrommel 29 anliegende Preßband 32 aufgebracht und mit dem Preßband 32 zum Einlauf in die Doppelbandpresse geführt. Die Glasfasergewebe-Bahn 5 wird ebenfalls zwischen die beiden Preßbänder 32, 33 am Einlauf in die Doppelbandpresse eingeführt und kommt in der Einlaufzone 56 mit dem Film 8 in Berührung, so daß in der Reaktionszone 34 der Doppelbandpresse die Imprägnierung der Glasfasergewebe-Bahn 5 mit dem Epoxidharz zum Prepreg, wie bereits beschrieben, durchgeführt werden kann.

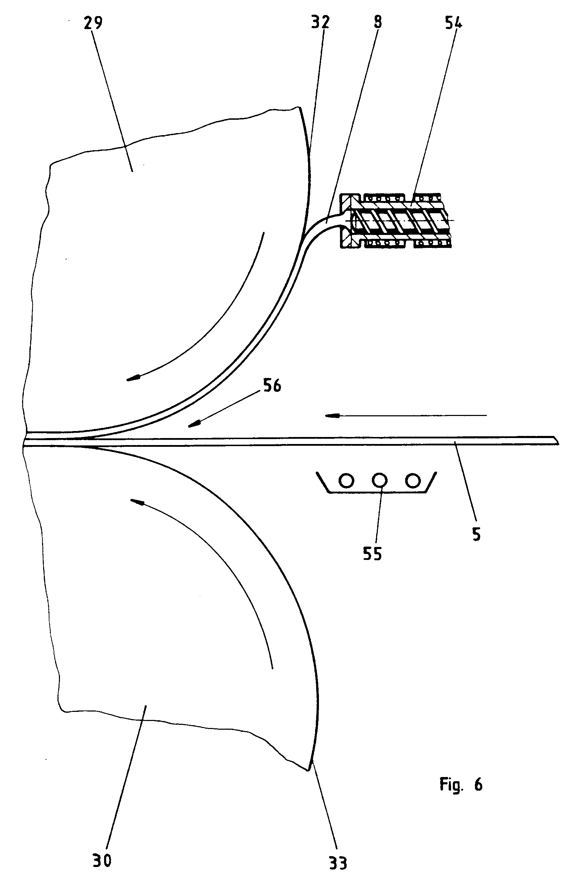

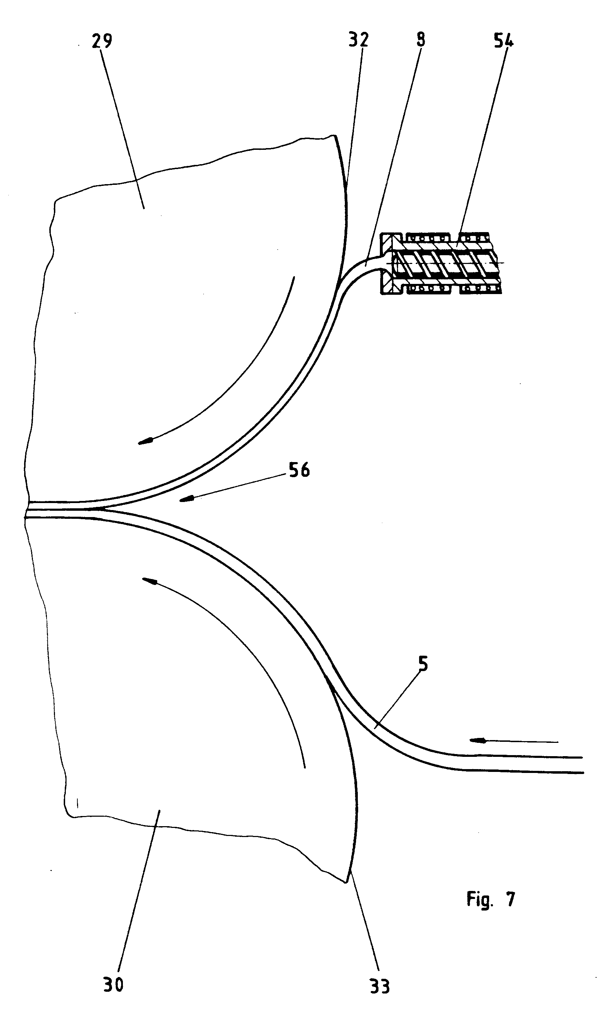

Die Glasfasergewebe-Bahn 5 wird gemäß den obigen Ausführungsformen mit Raumtemperatur in die Doppelbandpresse 1 eingeführt. Zur weiteren Erhöhung der Vorschubgeschwindigkeit des Schichtgebildes durch die Doppelbandpresse 1 kann die Glasfasergewebebahn 5 vor Einführung in die Doppelbandpresse 1 auch vorgewärmt werden, vorzugsweise auf eine Temperatur zwischen 60 und 120 ⁰C. Wie in Figur 6 zu sehen ist, befinden sich am Einlauf in die Doppelbandpresse 1 Infrarotstrahler 55, die auf die Glasfasergewebe-Bahn 5 einwirken, um so eine Vorwärmung der Glasfasergewebe-Bahn 5 zu bewirken. In einer weiteren Ausführungsform nach Figur 7 wird die Glasfasergewebe-Bahn 5 am Einlauf in die Doppelbandpresse 1 so geführt, daß sie am Preßband 33 anliegend entlang eines Teils des Umfangs der beheizten Umlenktrommel 30 in die Einlaufzone 56 geführt wird. Dadurch wird die Glasfasergewebe-Bahn 5 auf die gewünschte Temperatur vorgewärmt.

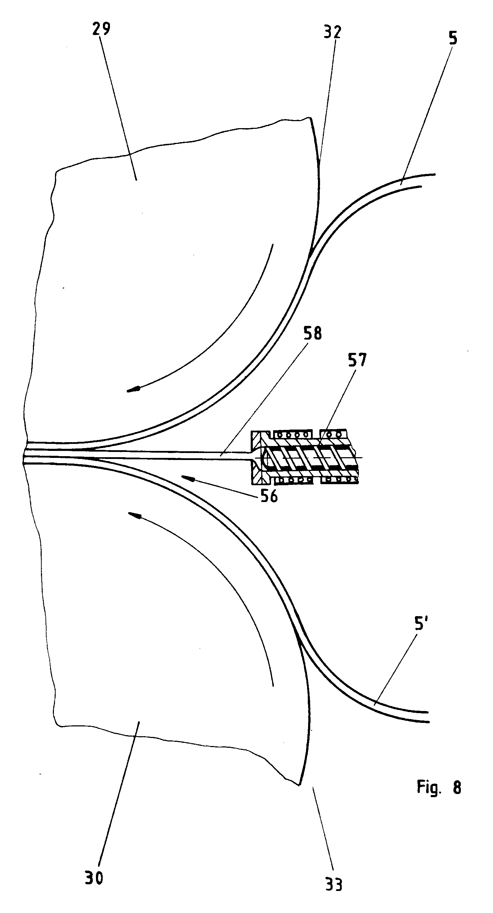

In einer weiteren Ausführungsform gemäß Figur 8 läßt sich auch eine doppelte Prepreg-Bahn herstellen. Dazu wird je eine Glasfasergewebe-Bahn 5 bzw. 5' über das Preßband 32 bzw. 33 entlang der Umlenktrommel 29 bzw. 30 in die Einlaufzone 56 der Doppelbandpresse eingeführt. Zwischen die beiden Glasfasergewebe-Bahnen 5, 5' wird ein Epoxidharz-Film 58 von einem Extruder 57 extrudiert, so daß in der Reaktionszone 34 der Doppelbandpresse 1 die beiden Glasfasergewebe-Bahnen 5, 5' gleichzeitig mit Harz imprägniert werden.

Wird zusätzlich eine drucklose Vorimprägnierung der Glasfasergewebe-Bahn mit dem Epoxid-Harz gewünscht, so kann der Extruder auch zwischen der auslaufseitigen Umlenktrommel 28 bzw. 31 und der einlaufseitigen Umlenktrommel 29 bzw. 30 in der Nähe des oberen rücklaufenden Bandtrums des Preßbandes 32 bzw. des unteren rücklaufenden Bandtrums des Preßbandes 33 angeordnet sein (siehe Figur 2). Die Epoxidharz-Schmelze wird dann als Film auf das rücklaufende Bandtrum des Preßbandes 32 bzw. 33 extrudiert und die Glasfasergewebe-Bahn 5 auf dieses rücklaufende Bandtrum aufgelegt. Falls gewünscht kann noch weitere Wärme diesem rücklaufenden Bandtrum mit bekannten Mitteln zugeführt werden. Die Harzschmelze dringt dann drucklos in die Glasfasergewebe-Bahn 5, die vom rücklaufenden Bandtrum des Preßbandes 32, 33 zur Einlaufzone der Doppelbandpresse transportiert wird, bis zu einem bestimmten Grad ein, so daß bis zum Erreichen der Einlaufzone eine gewisse Vorimprägnierung der Glasfasergewebe-Bahn 5 stattgefunden hat. Von der Einlaufzone wird die Glasfasergewebe-Bahn 5 mit der Harzschmelze weiter in die Reaktionszone 34 eingeführt, wo die endgültige Imprägnierung, wie weiter oben beschrieben, mit Vorhärtung des Harzes bis zum B-Zustand durchgeführt wird.

Es ist auch möglich, mehrere Extruder 3 oder mehrere, von einem Extruder versorgte Breitschlitzdüsen vor der Doppelbandpresse 1 anzuordnen, die jeweils einen Film 8 aus Harz auf je eine von Vorratsrollen 4 abgewickelte Materialbahn 5 aufbringen und diese mit Harz versehene Materialbahnen 5, unter Umständen mit einer dazwischenliegenden Trennfolie gemeinsam in die Doppelbandpresse 1 einzuführen und dort die Imprägnierprozesse unter Einwirkung von Flächendruck und Wärme, wie weiter oben beschrieben, durchzuführen. Am Auslauf der Doppelbandpresse werden dann die einzelnen harzimprägnierten Materialbahnen 10 voneinander getrennt, auf jeweils einer Rolle 12 aufgewickelt und bis zur weiteren Verarbeitung gelagert.

Die Vorrichtung zur Durchführung des erfindungsgemäßen Verfahrens kann auch noch modifiziert werden, indem anstelle des Extruders 3 eine herkömmliche Streueinrichtung angeordnet wird, mit der das Festharz-Pulver bzw. die Festharz-Flocken auf die Materialbahn 5 gestreut werden. Die Materialbahn 5 mit dem aufgestreuten Festharz wird dann in die Doppelbandpresse 1 eingeführt und dort unter Flächendruck erwärmt. Dabei schmilzt das Festharz auf und dringt in die Materialbahn 5 ein, wobei diese, wie weiter oben beschrieben, mit Harz imprägniert wird.

Im folgenden soll noch ein konkretes Ausführungsbeispiel einer mit dem erfindungsgemäßen Verfahren und der Vorrichtung hergestellten Prepreg-Bahn angegeben werden.

Eine Glasfasergewebe-Bahn des Typs US-Style 7628 wurde mit einer mittels eines Extruders erzeugten Films aus Epoxidharz-Schmelze versehen. Der den Extruder verlassende Film besaß eine Dicke von 0,2 mm und eine Temperatur von 130 ⁰C. Das Epoxidharz bestand aus einem bromierten Epoxidharz vom FR4-Typ mit dicyandiamidischem Härter und einem Imidazol-Beschleuniger. Die einlaufseitigen Umlenktrommeln der Doppelbandpresse waren auf eine Temperatur von 80 ⁰C erwärmt. Die erwärmte Reaktionszone besaß eine Länge von 1500 mm und war auf eine Temperatur von 220 ⁰C erwärmt, die sich daran anschließende gekühlte Reaktionszone mit einer Länge von 500 mm war auf 40 ⁰C abgekühlt. In der Reaktionszone wurde ein Flächendruck von 15 bar ausgeübt. Bei einer Vorschubgeschwindigkeit von 20 m/min wurde ein qualitativ ausgezeichnetes, vollkommen blasenfreies Prepreg mit einem Vorhärtungsgrad von 50 % (B-Zustand) erhalten.

Das erfindungsgemäße Verfahren ist anhand der Herstellung von Prepreg-Bahnen, die aus mit Epoxidharz imprägnierten Glasfasergewebe-Bahnen bestehen, erläutert worden, da in der Praxis an solche Prepregs qualitativ besonders hohe Anforderungen gestellt werden. Es eignet sich jedoch zur Herstellung beliebiger harzimprägnierter Materialbahnen. Beispielsweise kann Melaminharz, Harnstoffharz, usw. sowie Papierbahnen, Glasfasermatten, und dergleichen verwendet werden. So lassen sich damit auch melaminharzimprägnierte Papierbahnen erzeugen, die zur Herstellung von dekorativen Laminaten verwendet werden. Schließlich läßt sich das erfindungsgemäße Verfahren auch gut bei der Imprägnierung von Materialbahnen mit thermoplastischen Harzen anwenden. Unter Umständen kann dann sogar auf die Erwärmung in der Doppelbandpresse verzichtet werden und lediglich eine Abkühlung unter Flächendruck auf die Materialbahn ausgeübt werden.

## Patentansprüche

1. Verfahren zur kontinuierlichen Herstellung von harzimprägnierten Materialbahnen, bei dem die harzfreien Materialbahnen von Rollen abgewickelt, mit einem durch Wärme, chemische Reaktionen oder Kühlung aus härtbartem Harz versehen und unter Wärmeeinwirkung behandelt werden, so daß das Harz die Materialbahn imprägniert und einen vorgehärteten Zustand erreicht und anschließend die harzimprägnierte Materialbahn auf eine Rolle aufgerollt oder in bogenförmige Abschnitte aufgeteilt wird, **dadurch gezeichnet,** daß das Harz in Form von lösungsmittelarmen oder lösungsmittelfreien Festharz in Form von Flocken oder Pulver zu einem Film extrudiert wird, dieser Film mit der Materialbahn zu einem Schichtgebilde zusammengeführt wird und anschließend dieses Schichtgebilde der Einwirkung von Flächendruck ausgesetzt wird.

2. Verfahren zur kontinuierlichen Herstellung von harzimprägnierten Materialbahnen, bei dem die harzfreien Materialbahnen von Rollen abgewickelt, mit einem durch Wärme, chemische Reaktionen oder Kühlung aus härtbartem Harz versehen und unter Wärmeeinwirkung behandelt werden, so daß das Harz die Materialbahn imprägniert und einen vorgehärteten Zustand erreicht und anschließend die harzimprägnierte Materialbahn auf eine Rolle aufgerollt oder in bogenförmige Abschnitte aufgeteilt wird, **dadurch gezeichnet,** daß das Harz in Form von lösungsmittelarmen oder lösungsmittelfreien Festharz als Flocken oder Pulver auf die Materialbahn aufgestreut wird und die mit dem aufgestreuten Harz versehene Materialbahn anschließend der Einwirkung von Flächendruck ausgesetzt wird.

3. Verfahren nach Patentanspruch 1 oder 2, **dadurch kennzeichnet,** daß unter der Einwirkung des Flächendrucks eine gleichzeitige Wärmezufuhr auf die mit Harz versehene Materialbahn erfolgt.

4. Verfahren nach Patentanspruch 1, 2 oder 3, **dadurch gekennzeichnet,** daß eine anschließende Abkühlung der mit Harz versehenen Materialbahn unter Einwirkung des Flächendrucks erfolgt.

5. Verfahren nach Patentanspruch 1, **dadurch gekennzeichnet,** daß die Temperatur des extrudierten Films zwischen 100 und 150 ⁰C liegt.

6. Verfahren nach Patentanspruch 3, **dadurch gekennzeichnet,** daß die mit Harz versehene Materialbahn auf eine Temperatur zwischen 200 und 300 ⁰C erwärmt wird.

7. Verfahren nach Patentanspruch 4, **dadurch gekennzeichnet,** daß die Abkühlung der mit Harz versehenen Materialbahn auf 20 bis 80 ⁰C erfolgt.

8. Verfahren nach einem der Patentansprüche 1 bis 7, **dadurch gekennzeichnet,** daß die Materialbahn vorgewärmt wird, bevor sie mit Harz versehen wird.

9. Verfahren nach Patentanspruch 8, **dadurch gekennzeichnet,** daß die Vorwärmung der Materialbahn auf eine Temperatur zwischen 60 und 120 ⁰C erfolgt.

10. Verfahren nach Patentanspruch 3 oder 4, **dadurch gekennzeichnet,** daß die Erwärmung oder Abkühlung der mit Harz versehenen Materialbahn entsprechend einem dem Harz angepaßten Temperaturprofil erfolgt.

11. Verfahren nach einem der Patentansprüche 1 bis 10, **dadurch gekennzeichnet,** daß der Flächendruck auf die mit Harz versehene Materialbahn zwischen den beiden, über je zwei Umlenktrommeln geführten Preßbändern einer kontinuierlich arbeitenden Doppelbandpresse ausgeübt wird.

12. Verfahren nach Patentanspruch 11, **dadurch gekennzeichnet,** daß die Materialbahn auf ein Preßband der Doppelbandpresse aufgelegt wird und anschließend das Harz als Film auf diese Materialbahn aufgebracht wird.

13. Verfahren nach Patentanspruch 11, **dadurch gekennzeichnet,** daß das Harz als Film auf ein Preßband der Doppelbandpresse aufgebracht wird und anschließend die Materialbahn auf den Film aufgelegt wird.

14. Verfahren nach Patentanspruch 11, **dadurch gekennzeichnet,** daß das Harz als Film zwischen zwei Materialbahnen eingebracht wird und das aus Film und Materialbahnen bestehende Gebilde anschließend zwischen die beiden Preßbänder einer Doppelbandpresse eingeführt wird.

15. Verfahren nach einem der Patentansprüche 1 bis 14, **dadurch gekennzeichnet,** daß die Materialzufuhr des Harzes bei der Extrusion oder bei der Streuung in Abhängigkeit vom Flächengewicht des in der harzimprägnierten Materialbahn befindlichen Harzanteils geregelt wird.

16. Verfahren nach Patentanspruch 15, **dadurch gekennzeichnet,** daß das Flächengewicht des Harzanteils in der harzimprägnierten Materialbahn anhand der Intensität von an der Materialbahn rückgestreuten oder durch die Materialbahn durchgetretenen Beta-Strahlen ermittelt wird.

17. Verfahren nach einem der Patentansprüche 1 bis 16, **dadurch gekennzeichnet,** daß als Harz ein duroplastisches Harz verwendet wird, das in der harzimprägnierten Materialbahn bis zum B-Zustand vorgehärtet wird.

18. Verfahren nach Patentanspruch 17, **dadurch gekennzeichnet,** daß ein Prepreg hergestellt wird, indem als Materialbahn eine Glasfasergewebe-Bahn und als Harz ein Epoxidharz verwendet wird.

19. Vorrichtung zur Durchführung des Verfahrens nach Patentanspruch 1, mit Abwickeleinheiten zur Aufnahme der Rollen für die harzfreien Materialbahnen, einer Einrichtung zum Aufbringen des durch Wärme, chemische Reaktionen oder Kühlung härtbaren Harzes auf die Materialbahn` einer Einrichtung zur Erwärmung der mit Harz versehenen Materialbahn und einer Aufwickeleinheit mit einer Rolle zur Aufwicklung der harzimprägnierten Materialbahn oder einer Querschneideeinheit zur Aufteilung der harzimprägnierten Materialbahn in bogenförmige Abschnitte, **dadurch gekennzeichnet,** daß die Einrichtung zur Aufbringung von Harz aus einem Extruder (3) zur Herstellung eines Filmes (8) aus einem lösungsmittelarmen oder lösungsmittelfreien Festharz (23) in Form von Flocken und Pulver besteht, die Einrichtung zur Erwärmung der mit Harz versehenen Materialbahn (5) eine einen Flächendruck ausübende, kontinuierlich arbeitende Doppelbandpresse (1) ist, die zwei übereinander angeordnete, über je zwei Umlenktrommeln (28, 29, 30, 31) geführte endlose Preßbänder (32, 33) besitzt, zwischen denen der Flächendruck ausgeübt wird, und Mittel zur Zusammenführung des Harzfilmes (8) mit der Materialbahn (5) vor der Doppelbandpresse (1) angeordnet sind.

20. Vorrichtung zur Durchführung des Verfahrens nach Patentanspruch 2, mit Abwickeleinheiten zur Aufnahme der Rollen für die harzfreien Materialbahnen, einer Einrichtung zum Aufbringen des durch Wärme, chemische Reaktionen oder Kühlung härtbaren Harzes auf die Materialbahn, einer Einrichtung zur Erwärmung der mit Harz versehenen Materialbahn und einer Aufwickeleinheit mit einer Rolle zur Aufwicklung der harzimprägnierten Materialbahn oder einer Querschneideeinheit zur Aufteilung der harzimprägnierten Materialbahn in bogenförmige Abschnitte, **dadurch gekennzeichnet,** daß die Einrichtung zum Aufbringen von Harz aus einer Pulverstreueinrichtung besteht, die über der unbeharzten Materialbahn (5) angeordnet ist, so daß das Harz als lösungsmittelarmes oder lösungsmittelfreies Festharz in Form von Flocken oder Pulver auf die Materialbahn (5) gestreut wird, mit Mitteln zur Einführung der mit Harz versehenen Materialbahn (5) in eine einen Flächendruck ausübende, kontinuierlich arbeitende Doppelbandpresse (1), die zwei übereinander angeordnete, über je zwei Umlenktrommeln (28, 29, 30, 31) geführte endlose Preßbänder (32, 33) besitzt, zwischen denen der Flächendruck ausgeübt wird.

21. Vorrichtung nach Patentanspruch 19, **dadurch gekennzeichnet,** daß der Extruder (3) eine Breitschlitzdüse (7) besitzt.

22. Vorrichtung nach Patentanspruch 21, **dadurch gekennzeichnet,** daß die Breitschlitzdüse (7) lippenregelbar mittels Profilverstellung ist.

23. Vorrichtung nach einem der Patentansprüche 19 bis 22, **dadurch gekennzeichnet,** daß an oder vor der Doppelbandpresse (1) Mittel zur Vorwärmung der Materialbahn (5) angeordnet sind.

24. Vorrichtung nach Patentanspruch 23, **dadurch gekennzeichnet,** daß die Mittel zur Vorwärmung aus Infrarotstrahlern (55) bestehen.

25. Vorrichtung nach Patentanspruch 23, **dadurch gekennzeichnet,** daß die einlaufseitigen Umlenktrommeln (29, 30) der Doppelbandpresse (1) beheizbar ausgebildet sind.

26. Vorrichtung nach Patentanspruch 25, **dadurch gekennzeichnet,** daß in der Nähe der einlaufseitigen Umlenktrommeln (29, 30) Mittel zur Führung der Materialbahn (5) auf das an der Umlenktrommel (29, 30) befindliche Preßband (32, 33) angeordnet sind.

27. Vorrichtung nach Patentanspruch 25, **dadurch gekennzeichnet,** daß in der Nähe der einlaufseitigen Umlenktrommeln (29, 30) Mittel zum Auflegen des Filmes (8) aus Harz auf das an der Umlenktrommel (29, 30) befindliche Preßband (5) angeordnet sind.

28. Vorrichtung nach einem der Patentansprüche 19 bis 27, **dadurch gekennzeichnet,** daß in der Druckplatte (37, 39) Mittel zur Erwärmung des in der Reaktionszone (34) befindlichen Preßbandes (32, 33) angeordnet sind.

29. Vorrichtung nach einem der Patentansprüche 19 bis 28, **dadurch gekennzeichnet,** daß in der Druckplatte (36, 38) Mittel zur Kühlung des in der Reaktionszone (34) befindlichen Preßbandes (32, 33) angeordnet sind.

30. Vorrichtung nach Patentanspruch 28 oder 29, **dadurch gekennzeichnet,** daß es sich bei den Mitteln zur Erwärmung oder Kühlung um wärmeleitende Elemente (51) handelt, die mit gutem Wärmeleitkontakt mit einer Fläche mit der Druckplatte (36, 37) in Verbindung stehen und mit einer weiteren Fläche an das Preßband (32, 33) angelegt werden.

31. Vorrichtung nach Patentanspruch 28, **dadurch gekennzeichnet,** daß die Druckplatte (37, 39) erwärmt ist.

32. Vorrichtung nach Patentanspruch 29, **dadurch gekennzeichnet,** daß die Druckplatte (36, 38) gekühlt ist.

33. Vorrichtung nach einem der Patentansprüche 28 bis 32, **dadurch gekennzeichnet,** daß die Druckplatte (36, 37, 38, 39) in mehrere einzelne Druckplatten aufgeteilt ist, die jeweils auf einer bestimmten Temperatur gehalten werden, um ein vorbestimmtes Temperaturprofil im Preßband (32, 33) zu erzeugen.

34. Vorrichtung nach einem der Patentansprüche 19 bis 33, **dadurch gekennzeichnet,** daß am Auslauf der Doppelbandpresse (1) Spitzenionisatoren angebracht sind, die auf die harzimprägnierte Materialbahn (10) einwirken.

35. Vorrichtung nach einem der Patentansprüche 19 bis 34, **dadurch gekennzeichnet,** daß Beta-Strahler vor der Doppelbandpresse (1) an der unbeharzten Materialbahn (5) und hinter der Doppelbandpresse (1) an der harzimprägnierten Materialbahn (10) angeordnet sind.

36. Vorrichtung nach Patentanspruch 35, **dadurch gekennzeichnet,** daß die Beta-Strahler quer über die Breite der Materialbahn (5) bzw. der harzimprägnierten Materialbahn (10) bewegbar angeordnet sind.

37. Vorrichtung nach einem der Patentansprüche 19 bis 36, **dadurch gekennzeichnet,** daß das Preßband (32, 33) der Doppelbandpresse (1) mit einer Trennschicht versehen ist.

38. Vorrichtung nach einem der Patentansprüche 19 bis 36, **dadurch gekennzeichnet,** daß Mittel zur Zuführung einer Trennfolie vor der Doppelbandpresse (1) angeordnet sind.
